(19) **Europäisches Patentamt / European Patent Office / Office européen des brevets**

(11) **EP 1 537 652 B1**

(12) **EUROPÄISCHE PATENTSCHRIFT**

(45) Veröffentlichungstag und Bekanntmachung des Hinweises auf die Patenterteilung:
**18.06.2008 Patentblatt 2008/25**

(21) Anmeldenummer: **03797174.4**

(22) Anmeldetag: **22.08.2003**

(51) Int Cl.:
*H03F 3/08* (2006.01)  *H03F 3/45* (2006.01)
*G01J 1/44* (2006.01)  *G01J 1/10* (2006.01)

(86) Internationale Anmeldenummer:
**PCT/DE2003/002813**

(87) Internationale Veröffentlichungsnummer:
**WO 2004/027985 (01.04.2004 Gazette 2004/14)**

(54) **PHOTODETEKTOR-ANORDNUNG UND VERFAHREN ZUR STÖRLICHTKOMPENSATION**

PHOTODETECTOR ARRANGEMENT AND METHOD FOR STRAY LIGHT COMPENSATION

ENSEMBLE PHOTODETECTEUR ET PROCEDE DE COMPENSATION DE LUMIERE PARASITE

(84) Benannte Vertragsstaaten:
**DE FR**

(30) Priorität: **13.09.2002 DE 10242690**
**21.01.2003 DE 10302402**

(43) Veröffentlichungstag der Anmeldung:
**08.06.2005 Patentblatt 2005/23**

(73) Patentinhaber: **Conti Temic microelectronic GmbH**
**90411 Nürnberg (DE)**

(72) Erfinder:
- **RIEDEL, Helmut**
  **D - 86697 Oberhausen (DE)**
- **VON DAHL, Andreas**
  **85051 Ingolstadt (DE)**
- **LANG, Christian**
  **83410 Laufen (DE)**
- **ZYWITZA, Friedrich**
  **85055 Ingolstadt (DE)**

(56) Entgegenhaltungen:
**WO-A-02/32114**      **WO-A2-02/33922**
**DE-A- 19 821 974**   **DE-A- 19 917 109**
**US-B1- 6 426 494**

**Beschreibung**

Die Erfindung betrifft eine Photodetektor-Anordnung und ein Verfahren zur Störlichtkompensation, insbesondere bei differenzsignalauswertenden Verfahren.

In der optischen Messtechnik werden Szenen häufig aktiv beleuchtet. Die Informationen zur Erzeugung des Szenenbildes werden im Allgemeinen in einem Element zur Bildaufnahme, dem Bildaufnehmer, generiert. Die Art und Form der vom Bildaufnehmer erzeugten Signale ist dabei stark abhängig vom angewandten Messprinzip sowie dessen Realisierungsformen.

Bei Bild gebenden Verfahren, die die Differenz von zwei oder mehreren Signalen verwerten, kommt es in Abhängigkeit des jeweiligen Mess- bzw. Funktionsprinzips bei der Erzeugung der Signale zu nicht nutzbaren Gleichanteilen, die den zur Verfügung stehenden Dynamikbereich einschränken. Darüber hinaus addiert sich zu der aktiven Beleuchtung (z. B. Infrarotlicht, moduliertes oder nicht moduliertes Licht) ein Gleichanteil durch vorhandenes Störlicht (Hintergrundlicht der Sonne, andere Lichtquellen wie Scheinwerfer, Leuchtröhren etc.).,Die Intensität der aktiven Beleuchtung kann hierbei unter der Intensität des Störlichts liegen. In diesen Fällen wird das Detektorsignal vom Störlicht dominiert und das gewünschte Nutzsignal aus der aktiven Beleuchtung nimmt nur einen geringen Bruchteil des Gesamtsignals ein.

Insbesondere differenzsignalauswertende Verfahren, bei denen Photodetektoren für Entfernungsmessungen nach dem Phasenkorrelationsverfahren eingesetzt werden, sind durch die Gleichanteile der in die Differenzbildung eingehenden Signale in ihrer Leistungsfähigkeit begrenzt. Beispiele aus der Fahrzeugtechnik hierfür sind 3D-Entfernungsbildkameras mit Photomischdetektoren (auch Photonic Mixer Devices, kurz PMD genannt).

Diese Problemstellung kann zwar im Allgemeinen durch Verwendung von Photodetektoren mit extrem großem Dynamikbereich etwas entschärft werden, doch bleibt bei solchen Detektoren die Frage nach einem hinreichend guten Signal/Rauschverhältnis dennoch bestehen. Auch bei Sensoren mit großem Dynamikbereich sind die durch die Gleichanteile hervorgerufenen Einschränkungen des Dynamikbereichs bei differenzsignalauswertenden Verfahren erheblich.

Derzeit sind in der Literatur verschiedene Konzepte für hochdynamische Photodetektoren beschrieben: Die dort beschriebenen Konzepte verwenden Bauelemente mit logarithmischer Kennlinie für die Signalkompression (Höfflinger et al.: "IMS-Chips", Institut für Mikroelektronische Systeme, Stuttgart) oder steuern die Integrationszeit angepasst an die am Detektor auftretende Beleuchtungsintensität (M. Böhm et al., "High Dynamic Range Image Sensors in Thin Film on ASIC Technology for Automotive Applications", Advanced Microsystems for Automotive Applications, Springer-Verlag, Berlin, pp. 157-172, 1998). Detailliertere Informationen sind unter den Internet-Adressen von IMS-Chips (www.ims-chips.de) und Silicon Vision zu finden (www.siliconvision.de).

Eine Trennung von Photosignalen, die durch ein Zusammenwirken von aktiver Beleuchtung und Störlicht entstanden sind, kann mit Anordnungen und Verfahren gemäß dem Stand der Technik nur über zeitlich aufeinanderfolgende Messungen erreicht werden.

Dabei wird in einer ersten Messung das Photosignal durch die Summenwirkung von Störlicht und aktiver Beleuchtung ermittelt. In einer nachfolgenden zweiten Messung wird das Photosignal des Störlichts bei abgeschalteter aktiver Beleuchtung ermittelt. Die Reihenfolge der Messungen kann auch vertauscht werden. Das Nutzsignal kann anschließend durch Subtraktion des Störlichtsignals vom Gesamtsignal bestimmt werden.

Die WO 02/33922 beschreibt eine Photomischdetektor-Anordnung der gattungsbildenden Art, bei der ebenfalls eine Kompensationseinheit zur Kompensation von zugrundeliegenden Gleichanteilen vorgesehen ist

Darüber hinaus ist aus der WO 02/32114 noch ein optischer Sensor zu entnehmen, bei dem ebenfalls eine Kompensation von Gleichanteilen vorgesehen ist.

Ausgehend davon liegt der Erfindung die Aufgabe zugrunde, eine Photodetektor-Anordnung zur Störlichtkompensation sowie ein Verfahren zum Betreiben einer solchen Photodetektor-Anordnung anzugeben, mittels denen eine besonders hohe Unterdrückung bzw. Kompensation des durch Störlicht hervorgerufenen Photosignalanteils ermöglicht ist.

Die erstgenannte Aufgabe wird erfindungsgemäß gelöst durch eine Photodetektor-Anordnung zur Störlichtkompensation mit einer Photodetektoreinheit zur Erfassung und Bestimmung von mindestens zwei Messsignalen und mit einer Differenzeinheit zur Differenzbildung der Messsignale, wobei zwischen der Photodetektoreinheit und der Differenzeinheit eine Kompensationseinheit zur Kompensation von das jeweilige Messsignal zugrundeliegenden Gleichanteilen vorgesehen ist.

Die Erfindung geht dabei von der Überlegung aus, dass zur Steigerung der Leistungsfähigkeit einer Photodetektor-Anordnung ein möglichst großer Teil des Dynamikbereich eines zugehörigen Photodetektoreinheit für die Erfassung und Bestimmung des differenzbildenden Anteils der Mess- oder Nutzsignale verwendbar ist. Daher sollten die Mess- oder Nutzsignale um diejenigen Signalanteile reduziert werden, welche nicht durch Störsignale verursacht sind. Für eine größtmögliche Kompensation von Störanteilen im Messsignale sollte bei einem anhand von mehreren Messsignalen ausgeführten differenzauswertenden Verfahren sollten die Messsignale differenziert erfasst und bestimmt werden. Insbesondere sollte für jedes einzelne Messsignal eine Möglichkeit gefunden werden, mit denen die insbesondere durch Gleichanteile gebildeten Störanteile der aufgenommenen Messsignale unterdrückt bzw. minimiert werden können. Hierzu ist unmittelbar nach der Photodetektoreinheit eine Kompensationseinheit vorgesehen zur Unterdrückung bzw. Kompensation des vom Störlicht hervorgerufenen Gleichanteils im jeweiligen Mess- oder Nutzsignal. Hierdurch ist sichergestellt, dass eine Unterdrückung bzw. Kompensation der durch das Messprinzip bedingten Gleichanteile des Mess- oder Photosignals innerhalb nur einer Messung direkt im photosensitiven Bauelement erfolgt.

Für eine signalbezogene Kompensation der die Störsignale repräsentierenden Gleichanteile umfasst die Kompensationseinheit eine der Anzahl der Messsignale entsprechende Anzahl von Differenzmodulen. Durch eine derartige signal- und zudem gleichanteilabhängige Verarbeitung der dem differenzsignalauswertenden Verfahren zugrundeliegenden mehreren Mess- oder Photodetektorsignale unmittelbar nach der Erfassung sind Mehrfachmessungen sicher vermieden.

Zweckmäßigerweise umfasst die Kompensationseinheit eine Verstärkereinheit. Hierdurch ist in besonders einfacher Art und Weise eine Extrahierung des zur Differenzbildung nutzbaren Signalanteils vom Störsignal und vor allem die Erweiterung des Dynamikbereichs der Photodetektoreinheit bei der Detektion der Messsignale mit hohem Stör- bzw. Hintergrundpegel und geringem Nutzsignalanteil ermöglicht. Je nach Art und Aufbau der Verstärkereinheit kann ein statischer oder variabler Verstärkungsfaktor k eingestellt oder vorgegeben werden. In einer bevorzugten Ausführungsform ist eine für alle Messsignale gemeinsame Verstärkereinheit vorgesehen. Alternativ oder zusätzlich können mehrere Verstärkereinheit vorgesehen sein. Beispielsweise ist eine der Anzahl der erfassten Messsignale entsprechende Anzahl von Verstärkereinheiten vorgesehen.

Um auch im Falle von unbekannten, sich verändernden Mess- oder Nutzsignalen, eine Gleichanteilskompensation zu ermöglichen, umfasst die Kompensationseinheit zweckmäßigerweise ein Grenzwertmodul, insbesondere zur Detektion des Minimal- oder Maximalwerts der anliegenden Mess- oder Nutzsignale. Je nach Art und Einstellung des Grenzwertmoduls kann der Kompensationsgrad der Kompensationseinheit entsprechend eingestellt werden.

Insbesondere ist die Photodetektoreinheit als Photomischdetektor (auch Photonic Mixer Devices, kurz PMD genannt) ausgebildet. Die die Photodetektoreinheit, die Kompensationseinheit und die Differenzeinheit umfassende Photodetektor-Anordnung lässt sich in einer besonders einfachen und einen geringen Bauraum aufweisenden Ausführungsform als eine integrierte Schaltung, insbesondere mit integrierten Bauelementen umsetzen. Bevorzugt ist die Photodetektoreinheit als ein aktiver Pixelsensor (auch "Active Pixel Sensors", kurz APS genannt) ausgebildet, dessen Dynamikbereich beispielsweise weitestgehend für die Detektion des "differenzbildenden Anteils" einer aktiven Szenenbeleuchtung genutzt werden kann.

Die zweitgenannte Aufgabe wird erfindungsgemäß gelöst, bei einem Verfahren zur Störlichtkompensation von mittels einer Photodetektoreinheit erfassten Messsignalen, wobei vor einer Differenzbildung der Messsignale ein dem jeweiligen Messsignal zugrundeliegender Gleichanteil kompensiert wird.

Vorteilhafte Weiterbildungen der Erfindung sind Bestandteil der Unteransprüche. Das Verfahren kann mit Hilfe von integrierten elektronischen Bauelementen unmittelbar in einer Photodetektor-Anordnung umgesetzt werden, so dass Photodetektoren mit der beschriebenen Eigenschaft als Active Pixel Sensors (APS) ausgebildet werden können und sich in einfacher Weise z. B. in CMOS-Technologie realisieren lassen. Wesentlich ist auch, dass das Verfahren nicht auf Photodetektoren beschränkt ist, sondern prinzipiell auf alle Signale angewandt werden kann, die aus Stör- und Nutzsignal zusammengesetzt sind.

Die mit der Erfindung erzielten Vorteile bestehen insbesondere darin, dass durch die in der Photodetektor-Anordnung unmittelbar integrierte Kompensation der Störsignalanteile vor der Differenzbildung der zwei um die Störsignalanteile kompensierten Ausgangssignale die Übertragungskennlinie linearisiert und der Einfluss weitgehend gleichsinnig wirkender Störungen reduziert wird. Mit anderen Worten: Durch eine unmittelbare Kompensation von Störsignalanteilen, wie z. B. Störlicht, der erfassten und zur Differenzbildung vorgesehenen Photodetektorsignale ist die nachfolgende Differenzbildung weitgehend unbeeinflusst. Hierdurch werden die unmittelbar erfassten Photodetektorsignale in einen zu kompensierenden störenden Lichtanteil und in einen zur Differenzbildung nutzbaren Lichtanteil geteilt oder getrennt. Dies führt zu einer Erhöhung des nutzbaren Dynamikbereichs der Photodetektor-Anordnung. Durch die unmittelbare Verarbeitung der Messsignale unter Berücksichtigung der Kompensation von störbedingen Gleichanteilen ist eine derartige Photodetektor-Anordung für eine echtzeitfähige Signalaufnahme und somit für eine besonders schnelle, analoge Signalverarbeitung geeignet, beispielsweise weist eine derartige Photodetektor-Anordnung eine so genannte hohe Frame-Rate und kurze Messzeiten in bildaufnehmenden Systemen auf.

Darüber hinaus eignet sich die Photodetektor-Anordnung für Einzeldetektoren sowie für Zeilen- und Arrayanordnungen, z. B. für Photomischdetektoren (Kurz PMD's genannt). Ferner kann eine aufwendige A/D-Wandlung mit nachfolgender Werte-Speicherung und Subtraktion vermieden werden.

Vorteilhafte Ausgestaltungen und Weiterbildungen des Erfindungsgedankens sind der weiteren Beschreibung unter Bezugnahme auf die Zeichnung entnehmbar.

Ausführungsbeispiele der Erfindung werden nachfolgend anhand einer Zeichnung näher erläutert. Dabei zeigen:

Figur 1    eine verallgemeinerte, schematische Darstellung einer Photodetektor-Anordnung für ein differenzsignalbildendes Verfahren mit integrierter Kompensationseinheit;

Figur 2    eine allgemeine schematische Darstellung einer Photodetektor-Anordnung mit einer integrierten Verstärkereinheit;

Figur 3    hierfür eine allgemeine schematische Darstellung der Gleichanteilkompensationsschaltung zur Gewährleistung des maximalen Kompensationsgrades;

Figur 4    eine schematische Darstellung der Photodetektoranordnung zur Gleichanteilkompensation, der sich durch einen geringen Realisierungsaufwand auszeichnet;

Figur 5    das Zeitschema zur Ansteuerung der Photodetektor-Anordnung zur Gleichanteilkompensation, der sich durch einen geringen Realisierungsaufwand auszeichnet;

Figur 6    eine Photodetektor-Anordnung, mit der sich der maximale Gleichanteil-Kompensationsgrad $G_{Komp}$ = 100 % erreichen lässt;

Figur 7    das Zeitschema zur Ansteuerung der Photodetektor-Anordnung zur Gleichanteilkompensation mit Gewährleistung des maximalen Kompensationsgrades.

Gleiche beziehungsweise funktionsgleiche Elemente sind in allen Figuren - sofern nichts anderes angegeben ist - mit gleichen Bezugszeichen versehen worden.

Bevor genauer auf die oben genannten Photodetektor-Anordnungen eingegangen wird, erfolgt eine einleitende Erläuterung der grundlegenden Voraussetzungen und Eigenschaften des erfindungsgemäßen Verfahrens und der erfindungsgemäßen Photodetektor-Anordnung.

Die in den folgenden Ausführungen dargestellten Verfahren zur Gleichanteilkompensation dienen der Verbesserung von Anwendungen, bei denen die Differenz von mindestens zwei in ihrer Größe begrenzten, Gleichanteil behafteten Größen gebildet wird. Die in die Differenzbildung eingehenden Messsignale werden zu diesem Zweck reduziert, ohne dass die Differenz davon beeinflusst wird. Zur Vereinfachung wird hier und im Folgenden der Fall von zwei Signalen angenommen, wobei das Verfahren darauf nicht beschränkt ist.

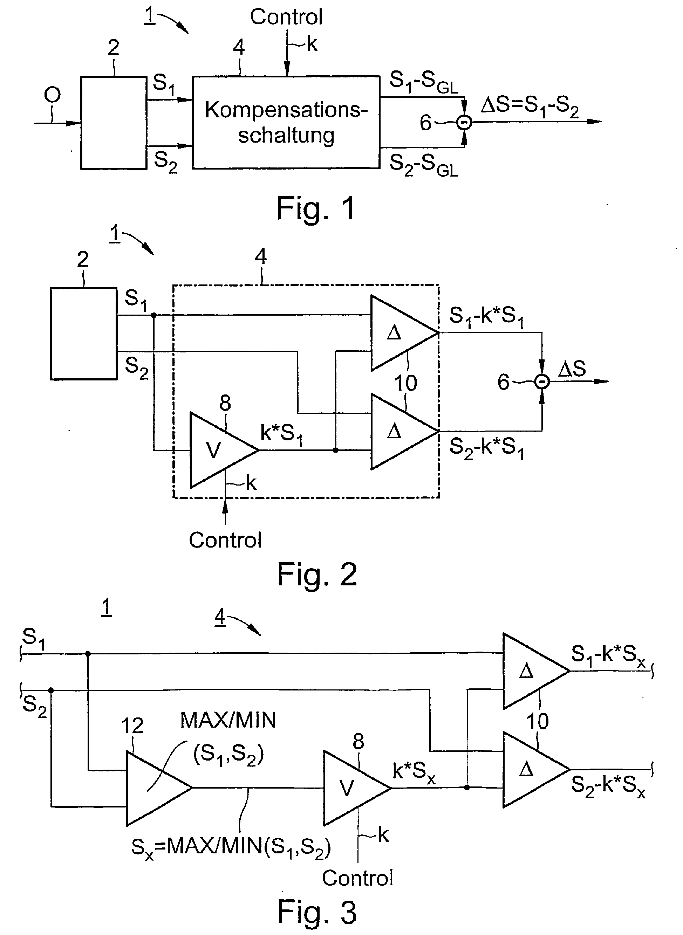

In Figur 1 ist eine verallgemeinerte, schematische Darstellung eine Photodetektor-Anordnung 1 zur Störlichtkompensation dargestellt. Die Photodetektor-Anordnung 1 umfasst eine Photodetektoreinheit 2 zur Erfassung und Bestimmung von zwei Messsignalen $S_1$ und $S_2$ aus einem optischen Signal O. Zur Bestimmung eines dem jeweiligen Messsignals $S_1$ bzw. $S_2$ zugrundeliegenden Nutzsignalanteils $S_{1\Delta}$ bzw. $S_{2\Delta}$ ist der Photodetektoreinheit 2 eine Kompensationseinheit 4 nachgeschaltet. Mittels eines Verstärkungsfaktors k ist ein der Kompensationseinheit 4 zugrundeliegender Kompensationsgrad für die Kompensation von dem jeweiligen Messsignal $S_1$ bzw. $S_2$ zugrundeliegenden Störanteilen, insbesondere Gleichanteilen $S_{GL}$ einstellbar. Zur Bestimmung des Differenzsignals $\Delta S$ anhand der jeweiligen Nutzsignalanteile $S_{1\Delta}$ bzw. $S_{2\Delta}$ werden die um die störbehafteten Gleichanteile $S_{GL}$ reduzierten Messsignale $S_1$ und $S_2$ einer Differenzeinheit 6 zugeführt.

Voraussetzendes Funktionsmerkmal des vorliegenden Kompensationsverfahrens ist hierbei die Differenzbildung zweier mit einem beispielsweise identischen Gleichanteil $S_{GL}$ und einem zugehörigen Nutzsignalanteil $S_{1\Delta}$ bzw. $S_{2\Delta}$ behafteter Signale $S_1$ und $S_2$. Dabei gilt:

$$S_1 = S_{1\Delta} + S_{GL} \quad \text{und} \quad S_2 = S_{2\Delta} + S_{GL} \quad \text{mit} \quad S_{GL} = k \cdot S_x \tag{1}$$

sowie

$$0 \le k \le 1 \tag{2}$$

Die Nutzsignalanteile $S_{1\Delta}$ und $S_{2\Delta}$ beschreiben dabei die ausschließlich zur Differenzbildung beitragenden Anteile des Nutzsignals. Der Verstärkungsfaktor k kann hierbei optional fest oder einstellbar sein. In der Regel gilt: Je nach Realisierungsform der Kompensationsschaltung kann es sich bei dem Signal $S_x$ um $S_1$ oder $S_2$, bzw. um das

kleinere oder größere beider Signale $S_{MIN}$ oder $S_{MAX}$ handeln.

Der Gleichanteil $S_{GL}$ kann hierbei wie folgt gebildet sein:

I. unbekannt, ausschließlich durch Störgrößen hervorgerufen;
II. verfahrens- und technologiebedingt in fester (= konstanter) Relation zu den Messsignalen $S_1$ und $S_2$;
III. unbekannt, als Summe aus Anteilen aus I. und II.

Die Größe, insbesondere der Wert der direkt in die Differenzbildung eingehenden Nutzsignalanteile $S_{1\Delta}$ und $S_{2\Delta}$ wird durch einen systemspezifischen Dynamikbereich vorgegeben. Der Dynamikbereich wird dabei durch die Auslegung von Speicherkapazitäten und/oder Schaltungsauslegungen zur Signalverstärkung bzw. -verarbeitung begrenzt. Zur Leistungssteigerung des differenzsignalbildenden Verfahrens durch Erhöhung des nutzbaren Anteils dieses Dynamikbereichs werden mittels der Kompensationseinheit 4 die Eingangs- oder Messsignale $S_1$ und $S_2$ direkt vor der Differenzbildung um den einem der beiden Messsignale $S_1$ und $S_2$ Proportionalitätsfaktor $k \cdot S_x$ reduziert.

Je nach Vorgabe des Proportionalitätsfaktors $k \cdot S_x$, der in Abhängigkeit vom Gleichanteil $S_{GL}$ der Messsignale $S_1$ bzw. $S_2$ gebildet wird und der je nach Ausführung der Kompensationseinheit 4 verschieden sein kann, wird der Proportionalitätsfaktor $k \cdot S_x$ bevorzugt jedoch wie folgt eingestellt:

$$S_{GL} \leq k \cdot S_x \tag{3}$$

Nachfolgend sind beispielhaft in den Figuren 2 und 3 zwei detailliertere Ausführungsformen für die Photodetektor-Anordnung 1 beschrieben, die sich hinsichtlich ihres Kompensationsgrades sowie ihrer Komplexität unterscheiden.

Vorerst wird hierbei zur Vereinfachung weiterhin die allgemeingültige Form der Photodetektor-Anordnung 1 nach Figur 1 beibehalten und näher die Ausführung der Kompensationseinheit 4 beschrieben.

Für den Fall, dass der Gleichanteil $S_{GL}$ mindestens einen Anteil besitzt, der in fester Relation zu den Messsignalen $S_1$ und $S_2$ steht (siehe oben unter Punkt II. bzw. III.), stellt die in Figur 2 schematisch dargestellte Photodetektor-Anordnung 1 eine sehr einfach zu realisierende Möglichkeit zur Gleichanteilkompensation dar. Der feste bzw. optional einstellbare Verstärkungsfaktor k gibt den minimalen relativen Gleichanteil $S_{GL}$ der Messsignale $S_1$ und $S_2$ an. Hierbei kann der signalreduzierende Term oder Proportionalitätsfaktor $k \cdot S_x$ beliebig als Funktion einer der Messsignale $S_1$ bzw. $S_2$ ausgelegt sein. In Figur 2 ist beispielhaft der Bezug zum Messsignal $S_1$ dargestellt. Zur Bildung einer anhand des Proportionalitätsfaktors $k \cdot S_x$ ausgeführten Gleichanteilskompensation $G_{Komp}$ des jeweils erfassten Messsignals $S_1$ bzw. $S_2$ umfasst die Kompensationseinheit 4 eine Verstärkereinheit 8 und zwei Differenzmodule 10.

Im Allgemeinen handelt es sich bei den Messsignalen $S_1$ und $S_2$ um unbekannte, sich verändernde Signale. Der Grad der durch den reduzierenden Proportionalitätsfaktor $k \cdot S_x$ gebildeten Gleichanteilskompensation $G_{Komp}$ ist mittels der Verstärkereinheit 8 variabel einstellbar. Beispielsweise ist der Grad der Gleichanteilskompensation $G_{komp}$ begrenzt durch einen Maximalwert gemäß $S_1 > S_2$ und einen Minimalwert gemäß $S_1 < S_2$ oder umgekehrt. Im Allgemeinen gilt:

$$G_{Komp} = \frac{k \cdot S_x}{S_{Min}} \quad \text{mit} \quad S_{Min} = MIN(S_1, S_2) \tag{4}$$

Je nach Art und Ausführung der Photodetektor-Anordnung 1 kann eine für alle Messsignale $S_1$ und $S_2$ gemeinsame Verstärkereinheit 8 vorgesehen sein. Alternativ oder zusätzlich können mehrere Verstärkereinheiten 8, z. B. je Messsignal $S_1$ bzw. $S_2$ eine zugehörige Verstärkereinheit 8 zur signalbezogenen Gleichanteilskompensation $G_{komp}$ vorgesehen sein.

Zur Gewährleistung eines maximalen Kompensationsgrades $G_{Komp\,Max}$ ist, wie in Figur 3 dargestellt, eine zusätzliche Schaltungskomponente, insbesondere ein Grenzwertmodul 12 zur Detektion eines Maximalwertes MAX bzw. eines Minimalwertes MIN aller am Grenzwertmodul 12 anliegenden Eingangs- oder Messsignale $S_1$ und $S_2$ vorgesehen.

Die maximale Gleichanteilkompensation $G_{Komp\,Max}$ wird wie folgt vorgegeben:

$$k \cdot S_x \stackrel{!}{=} S_{Min} \stackrel{!}{=} k \cdot S_{Max} \tag{5}$$

Der Proportionalitätsfaktor k·$S_x$ wird hierbei entweder direkt anhand des Minimalwerts MIN (= $S_{Min}$, bei k = 1) oder indirekt über einem proportionalen Zusammenhang zum Maximalwert MAX (= $S_{Max}$) bestimmt.

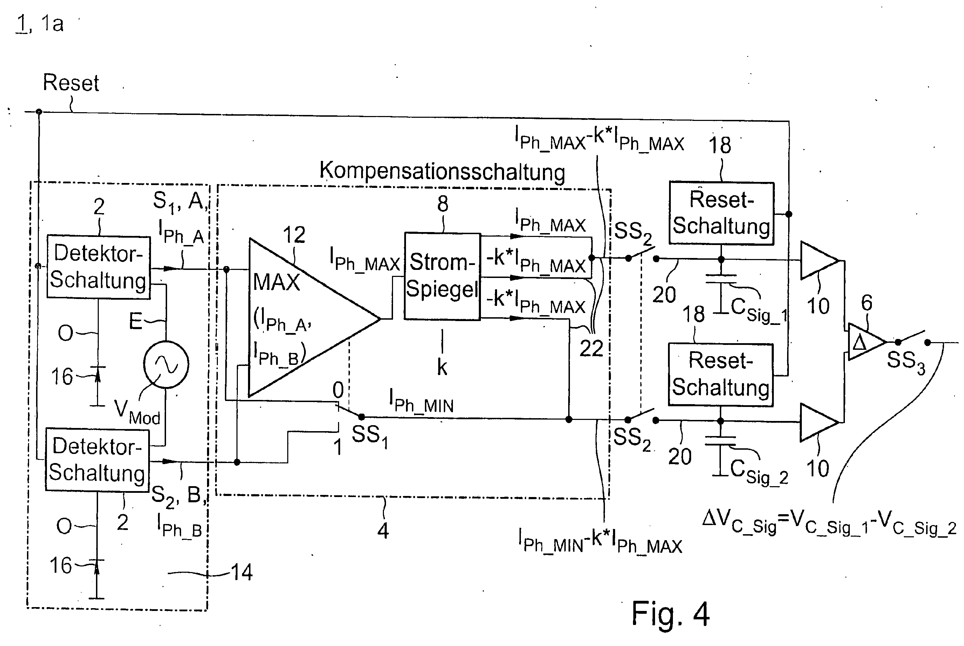

Besonders vorteilhaft ist die Anwendung der beschriebenen Gleichanteilkompensation in einer Photodetektor-Anordnung 1 eines speziellen Zweikanal-System mit als so genannte Photomischdetektoren 14 (auch Photonic Mixer Devices, kurz "PMD" genannt) ausgebildeten Photodetektoreinheiten 2, wie in Figur 4 gezeigt. Photomischdetektoren 14 werden als Bauelemente zur Mischung von elektrischen Signalen E und optischen Signalen O eingesetzt. Sie bestehen aus mindestens zwei paarweise angeordneten Photodetektoreinheiten 2, auf die sich Ladungsträger, die von einer aktiven Szenenbeleuchtung im Halbleiter generiert werden, bei der Mischung mit einem elektrischen Signal E nach einem bestimmten Schema verteilen. Der jeweiligen Photodetektoreinheit 14 ist dabei ein Photoelement 16 zur Erfassung des optischen Signals O zugeordnet.

Beispielsweise werden Photomischdetektoren 14 eingesetzt, um 3D-Bildinformationen zu erzeugen. Hierbei werden ausschließlich die Differenzen der in den paarweise angeordneten Photodetektoreinheiten 2 erfassten und bestimmten Messsignale $S_1$ (= $I_{Ph\_A}$) und $S_2$ (= $I_{Ph\_B}$) ausgewertet.

Der wesentliche Aspekt, der für eine Anwendung spricht, ist die Tatsache, dass die generierten Messsignale $S_1$ und $S_2$ neben den potentiellen, unbekannten Gleichanteilen $S_{GL}$, die beispielsweise durch Störlicht hervorgerufen werden, immer einen bekannten prinzipbedingten und somit mess- oder bestimmbaren Gleichanteil $S_{mGL}$ enthalten. Dieser bestimmbare Gleichanteil $S_{mGL}$ wird beispielsweise anhand eines mittleren maximalen Modulationskontrast $MK_{Max}$ vorgegeben gemäß:

$$\overline{MK}_{Max} = \frac{\overline{\left|(\Delta S)_{Max}\right|}}{\Sigma S \big|_{\left|(\Delta S)_{Max}\right|}} \tag{6}$$

Dabei wird der mittlere maximale Modulationskontrast $MK_{Max}$ beispielsweise durch die Variation von herstellungs- und layoutspezifischen Parametern, wie beispielsweise Halbleitermaterial und Bauteilgeometrien, bestimmt und kann daher nach der Fertigung experimentell bestimmt und als konstant betrachtet werden. Der Zusammenhang zwischen dem mittleren maximalen Modulationskontrast $MK_{Max}$ und dem minimalen, relativen Gleichanteil $S_{GL}$ der Signale $S_1$ und $S_2$ wird wie folgt vorgegeben:

$$\frac{S_{GL_{Min}}}{MAX(S_1, S_2)} = \frac{1 - \overline{MK}_{Max}}{1 + \overline{MK}_{Max}} \tag{7}$$

Hierdurch lässt sich der Zusammenhang zum Verstärkungsfaktor k des Proportionalitätsfaktor k·$S_x$ gemäß der Photodetektor-Anordnung 1 in Figur 2 wie folgt einstellen:

$$k_{Max} = \frac{1 - \overline{MK}_{Max}}{1 + \overline{MK}_{Max}} \tag{8}$$

Die in Figur 4 dargestellte Photodetektor-Anordnung 1 mit Photomischdetektoren 14, Kompensationseinheit 4 und Differenzeinheit 6 ist in einer besonders einfachen Ausführungsform als integrierte Schaltung beispielsweise aus Halbleiterelementen herstellbar, wobei alle Elemente unmittelbar am Photoelement 16 und am Photomischdetektor 14 auf dem Halbleiter angeordnet sein können. Eine derartige Photodetektor-Anordnung 1 stellt somit eine Ausführungsform für einen aktiven Pixelsensor 1a (auch Active Pixel Sensors, kurz APS genannt) dar.

Im Betrieb der Photodetektor-Anordnung 1 wird mittels einer Signalquelle $V_{Mod}$ das elektrische Signal E erzeugt, das im Photomischdetektor 14 mit dem jeweils von den beiden Photodetektoreinheiten 2 aufgenommenen optischen Signal O gemischt wird. Das Ergebnis der Mischung wird in Form der zwei Messsignale $S_1$ und $S_2$ als so genannte Photoströme $I_{Ph\,A}$ bzw. $I_{Ph\,B}$ über zugehörige Signalpfade A bzw. B zeitgleich bereitgestellt.

Grundsätzlich sind sämtliche Signalformen für die Umwandlung des optischen Signals O mit dem elektrischen Signal E in das elektrische Messsignal $S_1$ bzw. $S_2$ geeignet (z. B. Rechteck-, Sinus-, Dreieck-, Pseudo-Noise-, Pulsgruppenform etc.). Bevorzugt werden bei dem hier beschriebenen Verfahren bedingt durch die integrierte Ausführung zeitlichen Mittelwerte der jeweiligen Signalform gebildet.

Zur Initialisierung der Photodetektor-Anordnung 1 wird diese mittels einer dem jeweiligen Messsignal $S_1$ bzw. $S_2$ zugehörigen Reset-Schaltung 18 anhand eines Reset-Impulses in einen definierten Start- oder Ausgangszustand gesetzt. Der jeweiligen Reset-Schaltung 18 ist eine Integrationskapazität $C_{sig\,1}$ und $C_{Sig\,2}$ zugeordnet. Bei der Initialisierung werden die Integrationskapazitäten $C_{Sig\,1}$ und $C_{Sig\,2}$ mittels der jeweils zugeordneten Reset-Schaltung 18 auf einen definierten Spannungspegel geladen, zum anderen erfolgt die Initialisierung der beiden Photoelemente 16 über die im Photomischdetektor 14 angeordneten Photodetektoreinheiten 2.

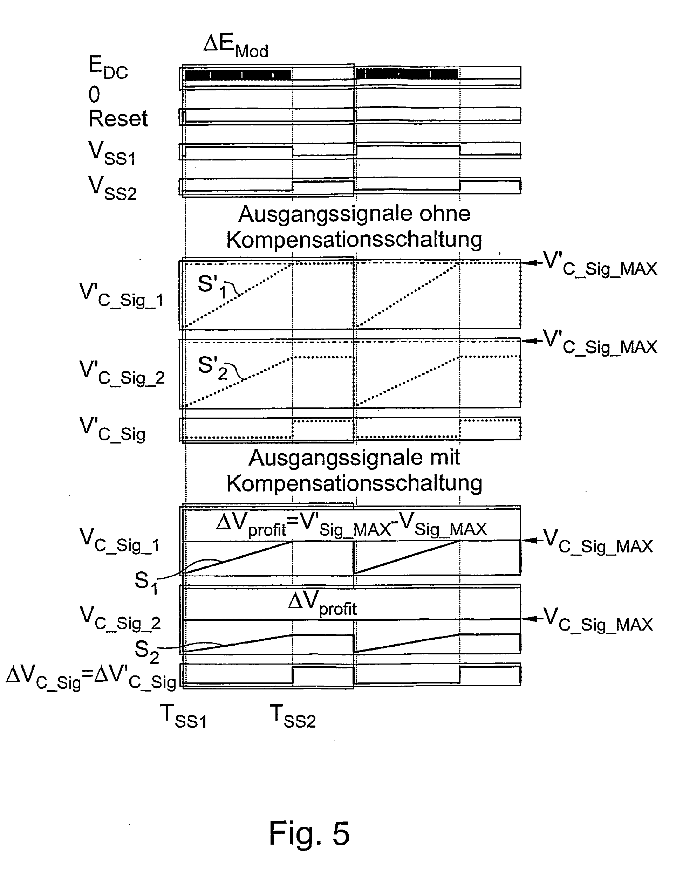

Die Funktionsweise der Photodetektor-Anordnung 1 gemäß Figur 4 wird durch das in Figur 5 dargestellte Zeitschema ergänzt und nachfolgend näher erläutert. Figur 5 zeigt das Zeitschema zur Ansteuerung der Photodetektor-Anordnung 1 zur Gleichanteilkompensation. Zur Verdeutlichung der Wirkungsweise enthält dieses sowohl die Darstellungen der Ausgangssignalverläufe ohne als auch mit Gleichanteilkompensationsschaltung.

Zum Zeitpunkt $T_{SS1}$ wird gleichzeitig mit dem Schließen des Schalters $SS_1$ eine aktive Szenenbeleuchtung $\Delta E_{MOD}$ eingeschaltet. Die daraus resultierenden elektrischen Signale E und die optischen Signale O werden mittels der zwei paarweise angeordneten Photodetektoreinheiten 2 des Photomischdetektors 14 in die die Messsignale $S_1$ und $S_2$ repräsentierenden Photoströme $I_{Ph\,A}$ und $I_{Ph\,B}$ auf den Signalpfaden A und B umgewandelt. Der Gesamtphotostrom oder das jeweilige Messsignal $S_1$ bzw. $S_2$ setzt sich dabei zusammen aus der den Nutzsignalanteil $S_{1/2\Delta}$ bildenden aktiven Szenenbeleuchtung $\Delta E_{MOD}$ und einem den störbehafteten Gleichanteil $S_{GL}$ bildenden Störlicht $E_{DC}$ der Szene.

Die Signalintegration an den Integrationskapazitäten $C_{Sig\,1}$ und $C_{Sig\,2}$ erfolgt ohne Kompensationsschaltung gemäß den Signalverläufen $V'_{C\,Sig\,1}$ und $V'_{C\,Sig\,2}$ und mit Kompensationsschaltung gemäß den Signalverläufen $V_{C\,Sig\,1}$ und $V_{C\,Sig\,2}$ bis zum Zeitpunkt $T_{SS2}$, bis zu dem der Schalter $SS_1$ geöffnet und Schalter $SS_2$ geschlossen wird. Hierbei sei vorausgesetzt, dass sich die Integrationskapazitäten $C_{Sig\,1}$ und $C_{Sig\,2}$ zu keinem Zeitpunkt im Bereich der Sättigung befinden und somit von einer annähernd linearen Integration ausgegangen werden kann. Bis zum erneuten Reset-Impuls werden die Signalverläufe $V'_{C\,Sig\,1}$ und $V'_{C\,Sig\,2}$ ohne Kompensation bzw. $V_{C\,Sig\,1}$ und $V_{C\,Sig\,2}$ mit Kompensation entsprechend an den Integrationskapazitäten $C_{Sig\,1}$ und $C_{Sig\,2}$ gehalten.

Dabei liegt am Schalter $SS_2$ das über die entsprechende Verstärkereinheit 8 und dem Subtrahierer oder Differenzmodul 10 gebildete kompensierte Messsignal $S_1$ bzw. $S_2$ als Differenzsignal $\Delta C_{Sig}$ an einer der beiden Ausleseleitungen 20 an.

Der Vergleich der Messsignale $S'_1$ und $S'_2$ der Signalverläufe $V'_{C\,Sig\,1}$ und $V_{C\,Sig\,2}$ (ohne Kompensationsschaltung) mit den Messsignalen $S_1$ und $S_2$ der Signalverläufe $V_{C\,Sig\,1}$ und $V_{C\,Sig\,2}$ (mit Kompensationsschaltung) zeigt, dass die Gleichanteilskompensation $G_{Komp}$ die Spannungspegel an den Integrationskapazitäten $C_{Sig\,1}$ und $C_{Sig\,2}$, die zur Differenzbildung verwertet werden, reduziert werden, ohne dass das Differenzsignal $\Delta V_{C\,sig}\,(=\Delta V'_{C\,Sig})$ davon beeinflusst wird. Die Reduzierung der Spannungspegel eröffnet die Möglichkeit, zusätzliche optisch generierte Ladungsträger auf die Kapazitäten $C_{Sig\,1}$ und $C_{Sig\,2}$ integrieren zu können. Hierdurch wird ein zusätzlich nutzbarer Teil des vorhandenen Dynamikbereichs geschaffen, was einer Erhöhung des Dynamikbereichs gleichkommt. Der Absolutwert dieser Erhöhung ist bestimmt durch die Potentialdifferenz $\Delta V_{profit}$ und ergibt sich gemäß Figur 5 aus der Differenz der Signale $V'_{C\,Sig\,Max}$ und $V_{C\,Sig\,Max}$.

$$\Delta V_{profit} = V'_{C\_Sig\_Max} - V_{C\_Sig\_Max} \qquad (9)$$

Die Schlüsselfunktion der Kompensationsschaltung ist die Reduzierung des Gleichanteils $S_{GL}$ der die Messsignale $S_1$ und $S_2$ repräsentierenden Photoströme $I_{PhA}$ und $I_{Ph\,B}$ bevor diese auf die Kapazitäten $C_{Sig\,1}$ und $C_{Sig\,2}$ integriert werden.

Die gemäß Figur 4 ausgeführte Photodetektor-Anordnung 1 umfasst hierzu die als ein so genannter Stromspiegel ausgebildete Verstärkereinheit 8 realisiert. Auf Basis des Photostroms $I_{Ph\,A}$ (für $I_{Ph\,B}$ gilt Analoges) erzeugt eine so genannte Stromspiegelschaltung der Verstärkereinheit 8 durch Aufprägen des Verstärkungsfaktors k entsprechend kompensierte Ströme $k\,I_{Ph\,A}$ bzw. $I_{Ph\,A}$. Mit diesen lassen sich durch die Zusammenführung von entsprechenden Ausgangsleitungen 22 Differenzsignale $\Delta I_{Ph} = I_{Ph\,A} - k\,I_{Ph\,A}$ bzw. $\Delta I_{Ph} = I_{Ph\,B} - k\,I_{Ph\,A}$ auf sehr einfache Weise bilden. Der Verstärkungsfaktor k lässt sich beispielsweise über das Weiten-/Längen-Verhältnis (W/L) der CMOS-Transistoren der eingesetzten Stromspiegel oder über entsprechende Bias-Ströme einstellen. Der Vorteil dieser Schaltungsanordnung und des daraus resultierenden Verfahrens ist bedingt durch die Einfachheit der geringe Realisierungsaufwand, weiteres Verbesserungspotential liegt hingegen im schon weiter oben erwähnten nicht konstanten Kompensationsgrad.

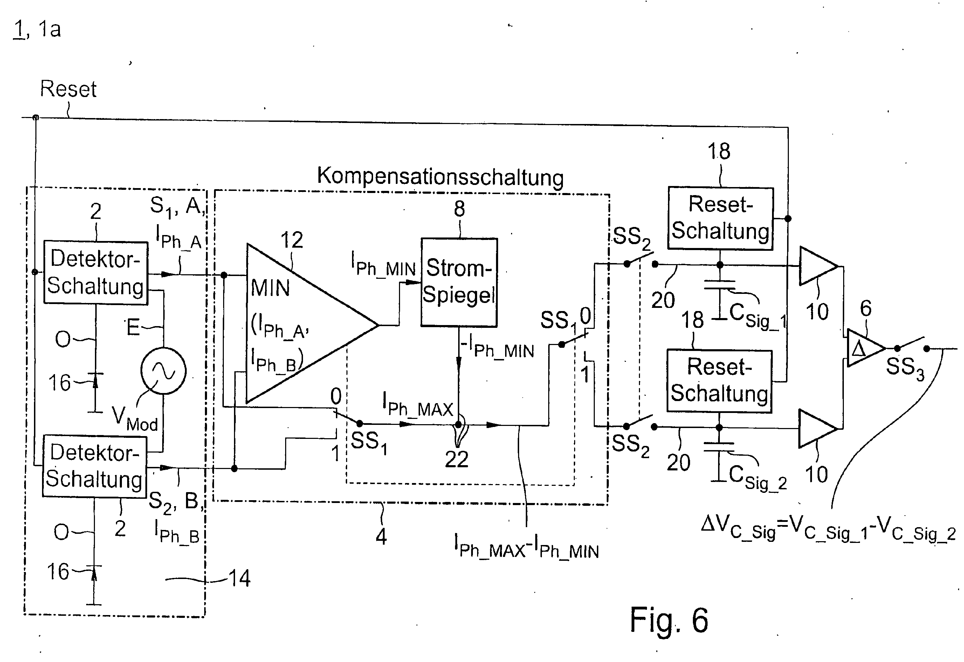

Figur 6 zeigt eine alternative Ausführungsform für eine Photodetektor-Anordnung 1, mit der sich, unabhängig vom Vorzeichen des Differenzsignals $\Delta I_{Ph} = I_{Ph\,A} - I_{Ph\,B}$, ein maximaler Kompensationsgrad $G_{Komp}$ von 100 % für den Gleichanteil $S_{GL}$ erreichen lässt.

Im Vergleich zu der in Figur 4 gezeigten Photodetektor-Anordnung 1 ist hier das Grenzwertmodul 12 als Detektion des Minimalwerts MIN mit zwei gekoppelten Wechselschaltern SS1 integriert. Die Auslegung der Stromspiegelschaltung mittels der Verstärkereinheit 8 ist hingegen vereinfacht ausgeführt.

Der kleinere der beiden Photoströme $I_{Ph\,A}$ und $I_{Ph\,B}$ stellt den bezüglich der Differenzbildung irrelevanten, maximalen Gleichanteil $S_{GL} = I_{Ph\,MIN}$ dar. Aus diesem Grund ist es notwendig, direkt nach der Reset-Phase, in der die Integrationskapazitäten $C_{Sig\,1}$ sowie $C_{Sig\,2}$ und die Photoelemente 16 initialisiert werden, den minimalen Photostrom $I_{Ph\,MIN}$ zu bestimmen.

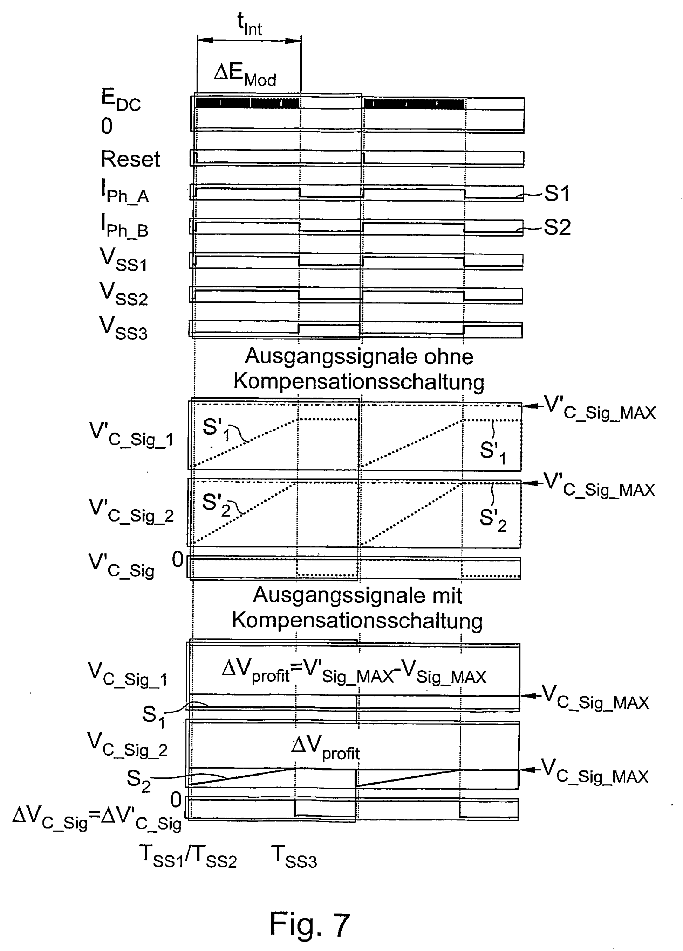

Das in Figur 7 zugehörige Zeitschema für die Photodetektor-Anordnung 1 zur Gleichanteilskompensation $G_{Komp}$ unter Berücksichtigung eines maximalen Kompensationsgrades $G_{Komp\,MAX}$ nach Figur 6 zeigt beispielhaft die Signalverläufe $V'_{C\,Sig\,1}$ bzw. $V'_{C\,Sig\,2}$ sowie $V_{C\,Sig\,1}$ bzw. $V_{C\,Sig\,2}$ für den Fall $I_{Ph\,A} < I_{Ph\,B}$.

Zum Zeitpunkt $T_{SS1}$ schaltet in diesem Fall mit Einschaltung der aktiven Szenenbeleuchtung $\Delta E_{MOD}$ der Schalter $SS_1$ in den Zustand "1" und $SS_2$ wird geschlossen. Der vom Grenzwertmodul 12 identifizierte Minimalwert MIN der anliegenden Photoströme $I_{Ph\_A}$ und $I_{Ph\_B}$, d. h. Strom $I_{Ph\_MIN}$ (z. B. Photostrom $I_{Ph\,A}$) erfährt durch die Stromspiegelanordnung der Verstärkereinheit 8 eine Vorzeichenumkehr und wird mit dem Strom $I_{Ph\,MAX}$ (z. B. Photostrom $I_{Ph\,B}$) zur Differenzbildung mittels Ausgangsleitungen 22 zusammengeführt. Zur Erhaltung des korrekten Vorzeichens bei der nachgeschalteten Differenzbildung erfolgt die Integration über die Schalter SS1 und $SS_2$ auf die Integrationskapazität $C_{Sig\,2}$. Das Potenzial an der Integrationskapazität $C_{Sig\,1}$ wird unverändert gehalten. Zum Zeitpunkt $T_{ss3}$ wird die Integration beendet und das Differenzsignal $\Delta C_{Sig}$ bis zum erneuten Reset-Impuls über Schalter $SS_3$ auf die Ausleseleitung 20 geführt.

Der Vergleich der Signalverläufe $V'_{C\,Sig\,1}$ und $V'_{C\,Sig\,2}$ (ohne Kompensationsschaltung) mit den Signalverläufen $V_{C\,Sig\,1}$ und $V_{C\,Sig\,2}$ (mit Kompensationsschaltung) zeigt, in welchem Maße die Spannungspegel an den Kapazitäten $C_{Sig\,1}$ und $C_{Sig\,2}$ durch die Kompensationsanordnung oder Kompensationseinheit 4 reduziert werden, ohne dass dabei das Ausgangsdifferenzsignal beeinflusst wird. Die Potenzialdifferenz $\Delta V_{profit}$ stellt den Kompensationsanteil, also den zusätzlich nutzbaren Teil des Dynamikbereichs dar.

Es sei an dieser Stelle erwähnt, dass die in Figur 6 dargestellte Photodetektor-Anordnung 1 alternativ auch mit einem als Maximumdetektor ausgebildeten Grenzwertmodul 12 ausgestattet werden kann. In diesem Fall würde eine Stromspiegelanordnung gemäß der Verstärkereinheit 8 nach Figur 4 eingesetzt werden. Eine solche Anordnung würde im Vergleich zur in Figur 6 aufgeführten Verstärkereinheit 8 nicht den kompletten Gleichanteil der Photoströme $I_{Ph\,A}$ und $I_{Ph\,B}$ kompensieren, im Vergleich zur Kompensationsschaltung der Figur 4 würde sich jedoch eine Performancesteigerung aufgrund des konstanten Kompensationsgrades ergeben.

Die hier beschriebenen verschiedenartigen und eine Gleichanteilskompensation bewirkenden Photodetektor-Anordnungen 1 weisen einen gegenüber herkömmlichen Anordnungen bedeutend höheren Dynamikbereich auf, der eine erhebliche Steigerung der Leistungsfähigkeit solcher Bauelemente in technischen Anwendungen zur Folge hat.

Das Verfahren kann sowohl für eine einzelne Photodetektoreinheit 2 als auch für eine Zeilen- oder Arrayanordnung von Detektoren 2 eingesetzt werden.

Die vorgeschlagenen Photodetektor-Anordnungen 1 können in einer Zeilenanordnung als Bildaufnehmer in Zeilenkameras Anwendung finden. Weiterhin sind Zeilenanordnungen als optische Mehrkanalsysteme zur Trennung unterschiedlicher Modulationskanäle möglich. Die Ansteuerung und Signalauslese der einzelnen Pixel solcher Zeilenanordnungen erfolgt üblicherweise mit Multiplexerbausteinen.

Entsprechendes gilt für eine zweidimensionale Matrix-Anordnung, wie sie in Flächensensoren für Videokameras verwendet wird. Multiplexerbausteine werden dabei zur Ansteuerung und Auslese der Detektorelemente jeweils für die Zeilen und die Spalten der Matrix-Anordnung eingesetzt.

Die vorliegende Erfindung wurde anhand der vorstehenden Beschreibung so dargestellt, um das Prinzip der Erfindung und dessen praktische Anwendung bestmöglichst zu erklären, jedoch lässt sich die Erfindung bei geeigneter Abwandlung selbstverständlich in mannigfaltigen anderen Ausführungsformen realisieren.

Bezugszeichenliste

1    Photodetektor-Anordnung
2    Photodetektoreinheit
4    Kompensationseinheit
6    Differenzeinheit
8    Verstärkereinheit
10   Differenzmodule
12   Grenzwertmodul
14   Photomischdetektoren
16   Photoelement
18   Reset-Schalter
20   Ausleseleitung

22      Ausgangsleitung

| | |
|---|---|
| "1" | Zustand |
| A, B | Signalpfade |
| $C_{Sig\,1}$, $C_{Sig\,2}$ | Integrationskapazität |
| E | elektrische Signale |
| $E_{DC}$ | Störlicht |
| $G_{Komp}$ | Gleichanteilskompensation |
| $G_{Komp\,Max}$ | maximalen Kompensationsgrades |
| $I_{Ph\,A}$, $I_{Ph\,B}$ | Photoströme |
| $I_{Ph\,MAX}$ | maximaler Photostrom |
| $I_{Ph\,MIN}$ | minimaler Photostrom |
| k | Verstärkungsfaktor |
| $k\,I_{Ph\,A}$, $I_{Ph\,A}$ | Ströme |
| $k \cdot S_x$ | Proportionalitätsfaktor |
| MAX | Maximalwert |
| MIN | Minimalwert |
| $MK_{Max}$ | Modulationskontrast |
| O | optische Signale |
| $S_1$, $S_2$ | Messsignale mit Kompensation |
| $S'_1$, $S'_2$ | Messsignale ohne Kompensation |
| $S_{1\Delta}$, $S_{2\Delta}$ | Nutzsignalanteile |
| $S_1 > S_2$ | Maximalwert |
| $S_1 < S_2$ | Minimalwert |
| $S_{GL}$ | Gleichanteile |
| $S_{mGL}$ | messbare Gleichanteile |
| $S_{MIN}$, $S_{MAX}$ | Signale |
| $SS_1$, $SS_2$ | Schalter |
| $S_x$ | Signal |
| $T_{SS1}$, $T_{SS2}$, $T_{SS3}$ | Zeitpunkte |
| $V_{C\,Sig\,1}$ $V_{C\,Sig\,2}$ | Signalverläufe mit Kompensation |
| $V'_{C\,Sig\,1}$, $V'_{C\,Sig\,2}$ | Signalverläufe ohne Kompensation |
| $V_{C\,Sig\,Max}$ / $V'_{C\,Sig\,Max}$ | Signalverlauf für den Maximalwert mit/ohne Kompensation |
| $V_{Mod}$ | Signalquelle |
| W/L | Weiten-Längen-Verhältnis |
| $\Delta C_{Sig}$ | Differenzsignal |
| $\Delta E_{MOD}$ | Szenenbeleuchtung |
| $\Delta I_{PH} = I_{Ph\,A} - k\,I_{Ph\,A}$, $\Delta I_{PH} = I_{Ph\,B} - k\,I_{Ph\,A}$ | Differenzsignale |
| $\Delta S$ | Differenzsignal |
| $\Delta V_{profit}$ | Potentialdifferenz |
| $\Delta V_{C\,Sig}$, $\Delta V'_{C\,Sig}$ | Differenzsignale |

**Patentansprüche**

1. Photomischdetektor-Anordnung (1) zur Störlichtkompensation mit einer Photodetektoreinheit (2) zur Erfassung und Bestimmung von mindestens zwei Messsignalen ($S_1$, $S_2$) und mit einer Differenzeinheit (6) zur Differenzbildung der Messsignale ($S_1$, $S_2$) und einer Kompensationseinheit (4) zur Kompensation von dem jeweiligen Messsignal ($S_1$, $S_2$) zugrundeliegenden Gleichanteilen ($S_{GL}$, $S_{mGL}$), **dadurch gekennzeichnet, dass**

    - die Kompensationseinheit (4) zwischen der Photodetektoreinheit (2) und der Differenzeinheit (6) angeordnet ist und
    - eine der Anzahl der Messsignale ($S_1$, $S_2$) entsprechende Anzahl von Differenzmodulen (10) vorgesehen ist
    - und die Messsignale ($S_1$, $S_2$) in den Differenzmodulen (10) direkt vor der Differenzbildung in der Differenzeinheit (6) reduziert werden.

2. Photodetektor-Anordnung nach Anspruch 1, wobei die Kompensationseinheit (4) eine der Anzahl der Messsignale ($S_1$, $S_2$) entsprechende Anzahl von Differenzmodulen (10) umfasst.

**3.** Photodetektor-Anordnung nach Anspruch 1 oder 2, wobei die Kompensationseinheit (4) eine Verstärkereinheit (8) umfasst.

**4.** Photodetektor-Anordnung nach Anspruch 3, wobei eine für alle Messsignale ($S_1$, $S_2$) gemeinsame Verstärkereinheit (8) vorgesehen ist.

**5.** Photodetektor-Anordnung nach Anspruch 3, wobei eine der Anzahl der erfassten Messsignale ($S_1$, $S_2$) entsprechende Anzahl von Verstärkereinheiten (8) vorgesehen ist.

**6.** Photodetektor-Anordnung nach einem der Ansprüche 1 bis 5, wobei die Kompensationseinheit (4) ein Grenzwertmodul (12) umfasst.

**7.** Verfahren zum Betrieb einer Photomischdetektor-Anordnunn (1) nach einem der vorangehenden Ansprüche **dadurch gekennzeichnet, dass** zur Störlichtkompensation von mittels einer Photodetektoreinheit (2) erfassten Messsignalen ($S_1$, $S_2$) vor einer Differenzbildung der Messsignale ($S_1$, $S_2$) ein dem jeweiligen Messsignal ($S_1$, $S_2$) zugrundeliegender Gleichanteil ($S_{GL}$, $S_{mGL}$) kompensiert wird.

**8.** Verfahren nach Anspruch 7, **dadurch gekennzeichnet, dass** für die Messsignale ($S_1$, $S_2$) ein diese gemeinsam repräsentierender Gleichanteil ($S_{GL}$. $S_{mGL}$) bestimmt wird.

**9.** Verfahren nach Anspruch 7 oder 8, **dadurch gekennzeichnet, dass** für den Gleichanteil ($S_{GL}$, $S_{mGL}$) zumindest ein konstanter Faktor bestimmt wird.

**10.** Verfahren nach einem der Ansprüche 7 bis 9, **dadurch gekennzeichnet, dass** der Gleichanteil ($S_{GL}$, $S_{mGL}$) als eine Funktion eines der Messsignale ($S_1$, $S_2$) bestimmt wird.

**11.** Verfahren nach einem der Ansprüche 7 bis 10, **dadurch gekennzeichnet, dass** der Gleichanteil ($S_{GL}$, $S_{mGL}$) zumindest anhand eines mittleren maximalen Modulationskontrast bestimmt wird.

**Claims**

**1.** A photo-mix detector arrangement (1) for compensating interfering light with a photo detector unit (2) for recording and determining at least two measuring signals ($S_1$, $S_2$) and with a differential unit (6) for forming the differential of the measuring signals ($S_1$, $S_2$) and a compensation unit (4) for compensating the constant components ($S_{GL}$, $S_{mGL}$) which underlie the respective measuring signal ($S_1$, $S_2$),
**characterized in that**

- the compensation unit (4) is arranged between the photo detector unit (2) and the differential unit (6), and
- a quantity of differential modules (10) is provided which corresponds to the quantity of measuring signals ($S_1$, $S_2$)
- and the measuring signals ($S_1$,$S_2$) in the differential modules (10) are reduced directly prior to the differential formation in the differential unit (6).

**2.** A photo detector arrangement according to claim 1, wherein the compensation unit (4) comprises a quantity of differential modules (10) which corresponds to the quantity of measuring signals ($S_1$, $S_2$).

**3.** A photo detector arrangement according to either of claims 1 or 2, wherein the compensation unit (4) comprises a booster unit (8).

**4.** A photo detector arrangement according to claim 3, wherein a shared booster unit (8) is provided for all measuring signals ($S_1$, $S_2$).

**5.** A photo detector arrangement according to claim 3, wherein a quantity of booster units (8) is provided which corresponds to the quantity of recorded measuring signals ($S_1$, $S_2$).

**6.** A photo detector arrangement according to any one of claims 1 to 5, wherein the compensation unit (4) comprises a threshold value module (12).

**7.** A method for operating a photo-mix detector arrangement (1) according to any one of the preceding claims, **characterized in that** in order to compensate the interfering light of measuring signals ($S_1$, $S_2$) which are recorded by means of a photo detector unit (2), prior to a differential formation of the measuring signals ($S_1$, $S_2$), a constant part ($S_{GL}$, $S_{mGL}$) which underlies the respective measuring signal ($S_1$, $S_2$) is compensated.

**8.** A method according to claim 7, **characterized in that** for the measuring signals ($S_1$, $S_2$), a constant part ($S_{GL}$, $S_{mGL}$) which represents said measuring signals combined is determined.

**9.** A method according to either of claims 7 or 8, **characterized in that** for the constant part ($S_{GL}$, $S_{mGL}$), at least one constant factor is determined.

**10.** A method according to any one of claims 7 to 9, **characterized in that** the constant part ($S_{GL}$, $S_{mGL}$) is determined as a function of one of the measuring signals ($S_1$, $S_2$).

**11.** A method according to any one of claims 7 to 10, **characterized in that** the constant part ($S_{GL}$, $S_{mGL}$) is determined on the basis at least of one average maximum modulation contrast.


**Revendications**

**1.** Dispositif photodétecteur mélangeur (1) pour la compensation de lumière parasite avec une unité de photodétection (2) pour la détection et la détermination d'au moins deux signaux de mesure ($S_1$, $S_2$) et avec une unité de différence (6) pour l'opération de soustraction des signaux de mesure ($S_1$, $S_2$) et une unité de compensation (4) pour la compensation des composantes continues ($S_{GL}$, $S_{mGL}$) à la base du signal de mesure ($S_1$, $S_2$) respectif, **caractérisé en ce que**

- l'unité de compensation (4) est disposée entre l'unité de photodétection (2) et l'unité de différence (6) et
- un nombre de modules de différence (10) correspondant au nombre des signaux de mesure ($S_1$, $S_2$) est prévu
- et les signaux de mesure ($S_1$, $S_2$) dans les modules de différence (10) sont réduits directement avant l'opération de soustraction dans l'unité de différence (6).

**2.** Dispositif photodétecteur selon la revendication 1, l'unité de compensation (4) comprenant un nombre de modules de différence (10) correspondant au nombre des signaux de mesure ($S_1$, $S_2$).

**3.** Dispositif photodétecteur selon la revendication 1 ou 2, l'unité de compensation (4) comprenant une unité d'amplification (8).

**4.** Dispositif photodétecteur selon la revendication 3, une unité d'amplification (8) commune étant prévue pour tous les signaux de mesure ($S_1$, $S_2$).

**5.** Dispositif photodétecteur selon la revendication 3, un nombre d'unités d'amplification (8) correspondant au nombre de signaux de mesure ($S_1$, $S_2$) détectés étant prévu.

**6.** Dispositif photodétecteur selon l'une des revendications 1 à 5, l'unité de compensation (4) comprenant un module de valeur limite (12).

**7.** Procédé pour le fonctionnement d'un dispositif photodétecteur mélangeur (1) selon l'une des revendications précédentes, **caractérisé en ce qu'**une composante continue ($S_{GL}$, $S_{mGL}$) à la base du signal de mesure ($S_1$, $S_2$) respectif est compensée avant l'opération de soustraction des signaux de mesure ($S_1$, $S_2$), pour la compensation de lumière parasite de signaux de mesure ($S_1$, $S_2$) détectés au moyen d'une unité de photodétection (2).

**8.** Procédé selon la revendication 7, **caractérisé en ce que**, pour les signaux de mesure ($S_1$, $S_2$), une composante continue ($S_{GL}$, $S_{mGL}$) représentant ceux-ci simultanément est définie.

**9.** Procédé selon la revendication 7 ou 8, **caractérisé en ce qu'**au moins un facteur constant est défini pour la composante continue ($S_{GL}$, $S_{mGL}$).

**10.** Procédé selon l'une des revendications 7 à 9, **caractérisé en ce que** la composante continue ($S_{GL}$, $S_{mGL}$) est définie comme une fonction d'un des signaux de mesure ($S_1$, $S_2$).

11. Procédé selon l'une des revendications 7 à 10, **caractérisé en ce que** la composante continue ($S_{GL}$, $S_{mGL}$) est définie au moins à l'aide d'un contraste de modulation maximal moyen.

Fig. 1

Fig. 2

Fig. 3

Fig. 4

$\Delta E_{Mod}$

$E_{DC}$

0

Reset

$V_{SS1}$

$V_{SS2}$

Ausgangssignale ohne
Kompensationsschaltung

$V'_{C\_Sig\_1}$

$S'_1$

$V'_{C\_Sig\_MAX}$

$V'_{C\_Sig\_2}$

$S'_2$

$V'_{C\_Sig\_MAX}$

$V'_{C\_Sig}$

Ausgangssignale mit
Kompensationsschaltung

$V_{C\_Sig\_1}$

$\Delta V_{profit} = V'_{Sig\_MAX} - V_{Sig\_MAX}$

$S_1$

$V_{C\_Sig\_MAX}$

$V_{C\_Sig\_2}$

$\Delta V_{profit}$

$S_2$

$V_{C\_Sig\_MAX}$

$\Delta V_{C\_Sig} = \Delta V'_{C\_Sig}$

$T_{SS1}$    $T_{SS2}$

# Fig. 5

Fig. 6

$\Delta V_{C\_Sig} = V_{C\_Sig\_1} - V_{C\_Sig\_2}$

Reset

1, 1a

Kompensationsschaltung

Reset-Schaltung

$C_{Sig\_1}$

$C_{Sig\_2}$

Strom-Spiegel

$MIN(I_{Ph\_A}, I_{Ph\_B})$

$I_{Ph\_MIN}$

$-I_{Ph\_MIN}$

$I_{Ph\_MAX}$

$I_{Ph\_MAX} - I_{Ph\_MIN}$

$SS_1$

$SS_2$

$SS_3$

$S_1, A, I_{Ph\_A}$

$S_2, B, I_{Ph\_B}$

Detektor-Schaltung

$V_{Mod}$

E

6

8

10

12

14

16

18

20

22

2

4

0

1

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0233922 A

- WO 0232114 A

**In der Beschreibung aufgeführte Nicht-Patentliteratur**

- **HÖFFLINGER et al.** IMS-Chips. *Institut für Mikroelektronische Systeme*

- High Dynamic Range Image Sensors in Thin Film on ASIC Technology for Automotive Applications. **M. BÖHM et al.** Advanced Microsystems for Automotive Applications. Springer-Verlag, 1998, 157-172